# EUROPEAN PATENT APPLICATION

(11) **EP 4 187 627 A1**
(43) Date of publication of application: **31.05.2023**
(21) Application number: 21461626.0
(22) Date of filing: 27.11.2021
(51) Int. Cl.: H01L 51/44, H01L 27/30

(54) **A SINGLE-CELL PHOTOVOLTAIC MODULE FOR IOT APPLICATIONS**

(71) Applicant: Saule S.A., 02-676 Warszawa (PL)
(72) Inventor: Babu, Vivek, Wroclaw (PL); Teixera, Cristina, Wroclaw (PL); Forgacs, David, Wroclaw (PL); Kedzierski, Igor, Wroclaw (PL); Gervasio, Joao, Wroclaw (PL); Wojak, Adrian, Wroclaw (PL); Huzar, Mateusz, Wroclaw (PL)
(74) Representative: Kancelaria Eupatent.pl Sp. z.o.o

(57) **Abstract**

A single-cell photovoltaic module (11) comprising: a transparent substrate (101) at a first side of the photovoltaic module (11), a first electrode (102) deposited on the transparent substrate (101), a charge transporting layer (103) deposited on the first electrode (102), a photoactive layer (104) comprising perovskite material deposited on the charge transporting layer (103), a carbon layer (105) deposited at a second side of the photovoltaic module (11) opposite to the first side, at least one first external electric contact (111) connected to the first electrode (102) and at least one second external electric contact (112) connected to the carbon layer (105) so that the at least one second external electric contact (112) is put directly on the carbon layer (105), wherein the carbon layer (105) is a single uniform layer over the area of the photovoltaic module (11).

## Description

### TECHNICAL FIELD

The present disclosure relates to a single-cell photovoltaic module, suitable in particular for use at low lighting conditions, in particular for indoor use, especially to power small and low-power devices such as Internet of Things (IoT) devices.

### BACKGROUND

Recent advancements in the area of the Internet of Things (IoT) resulted in development of a variety of IoT devices for various applications, such as smart home sensors, elder care medical devices, transportation sensors, V2X (Vehicle to Everything) communicators, building automation devices, manufacturing line sensors, agricultural devices, maritime devices, metropolitan infrastructure devices, energy management, environment monitoring, military devices etc.

At least some of the devices operate in low lighting conditions, such as being located in shadowed areas or indoors, in remote locations where wired power supply is not available and therefore must be supplied from an alternative power supply. Typically, battery power is used, which has a disadvantage of the need to replace batteries.

As an alternative to battery power, it is known to use a photovoltaic module to generate electrical power. Typically, photovoltaic modules are installed as standalone devices, because of the large size of typical photovoltaic modules required to supply power enough for the device to operate.

### SUMMARY OF THE INVENTION

There is a need to overcome at least some of the problems discussed in the background section and to provide a photovoltaic module that is suitable for low lighting conditions, in particular for indoor use and has a high geometric fill factor so that it can be effectively used with small and low-power devices such as IoT devices.

In one aspect of the present invention, there is provided a single-cell photovoltaic module that comprises a transparent substrate at a first side of the photovoltaic module, a first electrode deposited on the transparent substrate, a charge transporting layer deposited on the first electrode, a photoactive layer comprising perovskite material deposited on the charge transporting layer and a carbon layer at a second side of the photovoltaic module, opposite to the first side. The carbon layer is designed to work as a second electrode of the photovoltaic module. At least one first external electric contact is connected to the first electrode and at least one second external electric contact is connected to the carbon layer so that the at least one second external electric contact is put directly on the active area of the module. The photovoltaic module is designed such that the carbon layer is a single uniform layer over substantially the whole area of the photovoltaic module, it means that the active area of the module is not compromised by interconnects and the carbon layer covers substantially the whole area of the first electrode apart from the areas of interconnection of the first external electric contact(s). In other words, the photovoltaic module is a single-cell module. The carbon layer is in contact with the charge interfacial region or the perovskite, therefore it contributes to power generation (it forms the active area of the photovoltaic module).

This is in contrast to conventional multi-cell photovoltaic modules wherein the active areas of single cells are restricted due to the sheet resistance of electrodes (the bigger the area, the bigger the sheet resistance and the worse the performance due to the limitation in electrical conductivity of electrodes), and therefore a conventional PV module consist of multiple cells connected in series. The cuts between the cells degrade the total active area of the module (the geometric fill factor) and creating cuts and interconnects between cells makes the production process relatively complex. Moreover, when creating the cuts during production of the module, there is a risk of damaging the photoactive material which is a starting point of degradation of the module. Moreover, short-circuits may form between the electrodes, specifically if two metal electrodes are used. This phenomenon can be defined as localized, highly conductive pathways between top and bottom electrodes and has negative effects on the device.

Using carbon in one of the electrodes is not particularly beneficial in outdoor environment due to the abovementioned sheet resistance. However, the inventors found that since indoor applications provide lower light intensity and lower current density, the sheet resistance does not play a significant role in device performance.

Therefore, the single-cell photovoltaic module as employed in the IoT device according to the invention, particularly useful for indoor applications, can have relatively large active area of the single cell, such as larger than 1 cm². The elimination of interconnects within the module makes its size much more compact (has a high geometric fill factor). It can be used for small-sized and low-powered IoT devices such that all components of the IoT device, in particular the operating electronic circuit, the communication module and the photovoltaic power supply can be integrated in a common casing.

In the single-cell module there is no need for laser cutting as between the cells of a multi-cell module, therefore it is easier to manufacture and eliminates the problems of degradation of the module and short-circuits as described above with reference to multi-cell modules.

Moreover, shadowing effects are eliminated, namely when the modules are connected by multiple cells in series and are illuminated non uniformly, the shaded cells can get reverse biased, acting as loads and drain power from fully illuminated cells. In worse cases this can create hot spots and the devices could be irreversibly damaged.

Moreover, the use of carbon as the counter electrode is particularly beneficial, because thanks to the intrinsic properties of carbon, it can work both as an electrode and a hole transporting material due to energy band alignment with the valence band of perovskite material. Because of that, the total amount of layers in the device can be reduced as the additional hole transport material is not required in such a case. Moreover, the carbon counter electrode replaces conventional metal electrode. So, there will be no short-circuits present between the two electrodes as in conventional multi-cell modules.

Last but not least, the single-cell module has improved aesthetics, as there are no visible cutting lines on its surface.

Preferably, the thickness of the single-cell photovoltaic module is from 100 micrometers to 1 mm. The single-cell photovoltaic module can be made of transparent materials and therefore the whole single-cell photovoltaic module can be flexible. Such module can be accommodated at various surfaces, both flat and curved.

The cell photovoltaic module may further comprise an electrically conductive interfacial region between the photoactive layer and the carbon layer that is adjacent to the flat photoactive layer and penetrates a porous surface of the carbon layer. The interfacial region can be made of a material selected from a group consisting of thermoplastics (e.g. PMMA, Polystyrene), conductive polymers (e.g. PEDOT:PSS, PTTA, poly(3-hexylthiophene-2,5-diyl) (P3HT)) small molecules, alkali halide salts (e.g. KI, LiF), and organic halides. The interfacial region provides a more efficient pathway for charge carrier extraction, (reduces defects on perovskite surface, increases surface contact area between perovskite and carbon and / or provides a better work function alignment between them). It can have a thickness preferably from 1 to 1000 nm.

The photovoltaic module may further comprise a carbon pole deposited on the first electrode at a position separated from the edges of a stack formed by the charge transporting layer, the photoactive layer and the carbon layer, wherein the first external electric contact is connected to the first electrode via the carbon pole and wherein an external planar surface of the carbon pole is coplanar with an external planar surface of the carbon layer. This facilitates connection of the electric contacts to charge receiving wires.

The photovoltaic module can be encapsulated by barrier layers that protect it from external moisture and gas. For example, a first barrier layer can be provided at one of the external planar surfaces of the module. The first barrier layer can be transparent and form the transparent substrate. In addition, a second barrier layer can be provided at an external planar surface of the module opposite to the first barrier layer.

The single-cell photovoltaic module may further comprise an adhesive that forms a rim around a stack of internal layers of the photovoltaic module.

The single-cell photovoltaic module may further comprise an external circumferential rim made of rubber. The rubber rim functions as an improved barrier against lateral water ingress as these materials exhibit lower water vapor transmission rates.

For the purposes of the present disclosure, the Internet of Things (IoT) device is considered herein as a physical device that is embedded with an operating electronic circuit (such as a circuit with a sensor, a processor, a light or sound generator, a display etc.) and a communication module (preferably wireless) to communicate with another device over the Internet or other communications networks.

In another aspect of the present invention, there is provided an IoT device that comprises a photovoltaic power supply is connected to supply electrical power to at least one of the operating electronic circuit or the communication module. The photovoltaic power supply comprises the single-cell photovoltaic module as described herein. The photovoltaic power supply may further comprise a battery to store electric charge generated by the photovoltaic module. Therefore, the photovoltaic power supply can be temporarily configurable to supply power to components of the IoT device depending on the temporal amount of electric charge generated by the photovoltaic module. This allows to effectively manage use of power by the IoT device.

The IoT device may be configured to operate in a full functionality mode wherein the power from the photovoltaic power supply is supplied to both the operating electronic circuit and to the communication module and in a limited functionality mode wherein the power from the photovoltaic power supply is supplied to solely to either the electronic circuit or to the communication module, wherein the limited functionality mode is activated when the amount of charge from the single-cell photovoltaic module is lower than a threshold and the full functionality mode is activated when the amount of charge from the single-cell photovoltaic module is higher than a threshold

The operating electronic circuit, the communication module and the photovoltaic power supply can be integrated in a common casing, which can be a single-element casing or a casing comprising a plurality of elements connected and movable with respect to each other. This allows to make a compact device that can be easily installed, in particular in places of low lighting conditions, due to use of particularly efficient photovoltaic power supply as described above.

### BRIEF DESCRIPTION OF DRAWINGS

Aspects and features of the present invention will become apparent by describing, in detail, exemplary embodiments of the present invention with reference to the attached drawings, in which:
Fig. 1 presents schematically a structure of a first embodiment of the single-cell photovoltaic module in a cross-section along the line A-A of Fig. 3;
Fig. 2 presents schematically a structure of a second embodiment of the single-cell photovoltaic module in a cross-section along the line A-A of Fig. 3;
Fig. 3 presents a schematically structure of the first or the second embodiment of the single-cell photovoltaic module in a view from the top;
Fig. 4 presents schematically a structure of a third embodiment of the single-cell photovoltaic module in a cross-section along the line A-A of Fig. 6;
Fig. 5 presents schematically a structure of a fourth embodiment of the single-cell photovoltaic module in a cross-section along the line A-A of Fig. 6;
Fig. 6 presents a schematically structure of the third or the fourth embodiment of the single-cell photovoltaic module in a view from the top;
Fig. 7 presents schematically a structure of a fifth embodiment of the single-cell photovoltaic module in a cross-section;
Fig. 8 presents schematically a structure of a sixth embodiment of the single-cell photovoltaic module in a cross-section;
Fig. 9 presents schematically a structure of a seventh embodiment of the single-cell photovoltaic module in a cross-section;
Fig. 10 presents schematically a structure of an eighth embodiment of the single-cell photovoltaic module in a cross-section;
Fig. 11 presents schematically a structure of a ninth embodiment of the single-cell photovoltaic module in a cross-section;
Fig. 12 presents schematically a structure of a tenth embodiment of the single-cell photovoltaic module in a cross-section;
Fig. 13 presents schematically a structure of an eleventh embodiment of the single-cell photovoltaic module in a cross-section;
Fig. 14 presents schematically a structure of a twelfth embodiment of the single-cell photovoltaic module in a cross-section;
Fig. 15 shows example current-voltage curve for a single-cell photovoltaic module;
Fig. 16 presents a schematic of an IoT device;
Fig. 17 presents a first example embodiment of the IoT device being an electronic shelf label;
Fig. 18 presents a second example embodiment of the IoT device being a sensor.

### DETAILED DESCRIPTION OF EMBODIMENTS

Reference will now be made to embodiments, examples of which are illustrated in the accompanying drawings. Aspects and features of the invention will be described with reference to the accompanying drawings. In the drawings, like reference numerals denote like elements. The present invention, however, may be embodied in various different forms and should not be construed as being limited only to the illustrated embodiments. Rather, the presented embodiments are provided as example so that this disclosure will be thorough and complete, and will fully convey the aspects and features of the present invention to those skilled in the art. It shall be understood that not all of the features shown in the embodiment are essential and the scope of the protection is defined not by means of literally shown embodiment, but by the features provided in the claims.

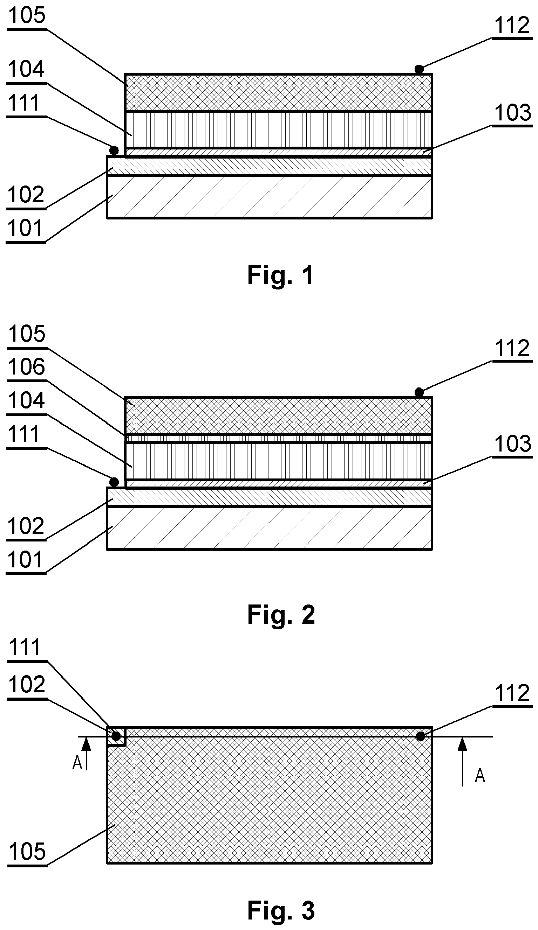

Fig. 1 presents schematically (not in scale, for clarity) a structure of a first embodiment of a single-cell photovoltaic module 10 in a cross-section along the line A-A of Fig. 3, as Fig. 3 presents schematically (not in scale, for clarity) a structure of the single-cell photovoltaic module in a view from the top. The single-cell photovoltaic module comprises a transparent substrate 101 at a first side of the single-cell photovoltaic module , a first electrode 102 deposited on the transparent substrate 101, a charge transporting layer 103 deposited on the first electrode 102, a photoactive layer 104 comprising perovskite material deposited on the charge transporting layer 103, and a carbon layer 105 deposited on the photoactive later 104, i.e. at a second side of the single-cell photovoltaic module , opposite the first side. The single-cell photovoltaic module is configured to be positioned such that its first side is facing the incoming light. The carbon layer 105 is a single uniform layer over substantially the whole area of the photovoltaic module, therefore the photovoltaic module can be called a single-cell module. A first external electric contact 111 is connected to the first electrode 102 and a second external electric contact 112 is connected to the carbon layer 105 so that the second external electric contact 112 is put directly on an active area of the single-cell photovoltaic module. The electric contacts 111, 112 are connected to electric wiring that transports the collected electric charge from the single-cell photovoltaic module.

The transparent substrate 101 can be made for example of PET (poly(ethylene terephthalate)), PEN ((poly(ethylene 2,6-naphthalate)), ETFE (poly(ethene-co-tetrafluoroethene)), and/or PI (polyimide).

The first electrode 102 can be made for example of transparent conductive electrode (TCO), made of ITO, IZO, FTO, and/or AZO, or an "IMI" structure, comprising at least 2 metal oxide layers with at least one metal layer in between - such as: ITO/Ag/ITO or AZO/Ag/AZO.

The charge transporting layer 103 can be made for example of SnO2, TiO2, ZnO, and PCBM or fullerenes different than PCBM capable for transport of electrons.

The carbon layer 105 can be prepared from carbon paste, which typically comprises graphite flakes of micron thickness and carbon black powder as carbon donating ingredients, which is blended with polymeric binders for connecting the carbon materials. The carbon layer has preferably a thickness in the range of 1-100 microns, more preferably 5-20 microns. It shall preferably have a sheet resistance less than 50 ohms / sq

The photoactive layer 104 is configured beneficially for low-light conditions. It shall have a bandgap higher than 1.5 eV, more preferably above 1.7 eV, and below 2.3 eV (higher bandgaps are beneficial in indoor applications). The perovskite material has preferably a general formula of ABX₃, wherein A is a cation with a 1+ charge (such as an alkylammonium cation, or metal cation such as Cs cation), B is a metal (for example, Pb, Sn, or Pb-Sn mixture), and X is a halide selected from the group consisting of I, Br and Cl, wherein the halides can be mixed. The total content of halides shall add up to 1, such as Br0.3 + 10.7. A higher bromide content is known to lead to photo induced phase segregation, but by using this specific composition in the architecture of this single-cell photovoltaic module, in low-light conditions this problem is not occurring. Preferable embodiments of the perovskite material include AB(Br0.3I0.7)₃; AB(Br0.25I0.75)₃, AB(Br0.2Cl0.05)₃, AB(Br0.25)₃, AB(Br0.25Cl0.05)₃, AB(Br0.3)₃, AB(Br0.3Cl0.025)₃, AB(Br0.3Cl0.05)₃, AB(Br0.35)₃, AB(Br0.4).

Fig. 2 presents schematically (not in scale, for clarity) a structure of a second embodiment of the single-cell photovoltaic module in a cross-section along the line A-A of Fig. 3. As compared to the first embodiment, the second embodiment of the single-cell photovoltaic module further comprises an electrically conductive interfacial region 106 between the photoactive layer 104 and the carbon layer 105. The interfacial region 106 can be made from thermoplastics (such as PMMA (poly(methyl methacrylate)) or polystyrene), conductive polymers, small molecules, alkali halide salts (such as potassium iodide (KI), lithium fluoride (LiF)), organic halides. The interfacial region 106 is adjacent to the flat photoactive layer 104 and penetrates the porous surface of the carbon layer, so that it improves the electrical contact area between the perovskite of the photoactive layer 104 and the carbon layer 105. Furthermore, the interfacial region 106 reduces the impact of defects on charge extraction, wherein the choice of materials.

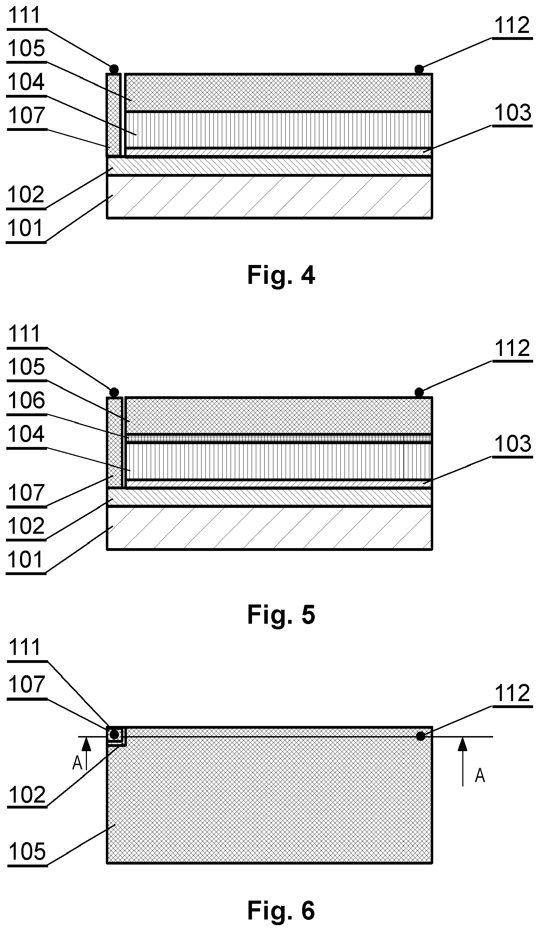

Fig. 4 shows a third embodiment of the single-cell photovoltaic module, in a cross-section along the line A-A of Fig. 6, as Fig. 6 presents schematically (not in scale, for clarity) a structure of the single-cell photovoltaic module in a view from the top. The third embodiment has the layered structure similar the first embodiment, with the following differences. A carbon pole 107 is deposited on the first electrode at a position separated from the edges of layers 103-105. The first electric contact 111 connected to the top of the carbon pole 107. The carbon pole 107 has a height equal to the height of the layers 103-105, so that the external planar surface of the carbon pole 107 is coplanar with the external planar surface of the carbon layer 105.

Fig. 5 shows a fourth embodiment of the single-cell photovoltaic module, which has a structure corresponding to a combination of the features of the second and third embodiments, namely it comprises layers 103-106 and the carbon pole 107.

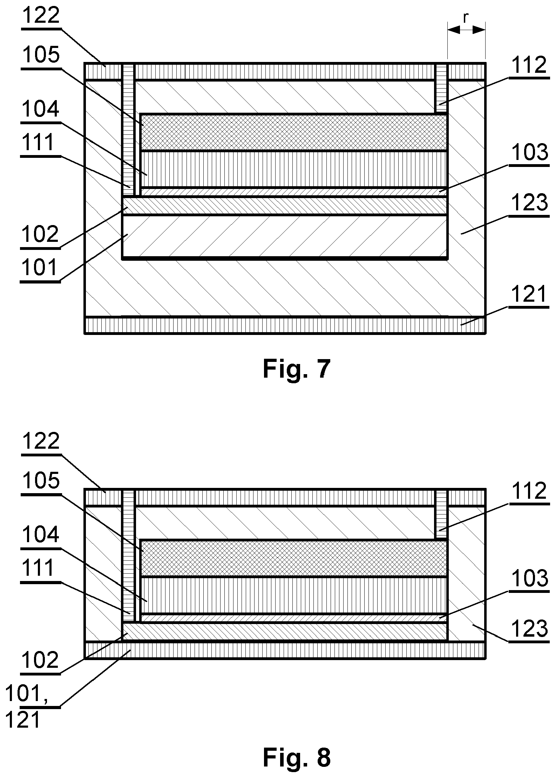

Fig. 7 shows in a cross-section a fifth embodiment of the single-cell photovoltaic module that corresponds to the first embodiment and is encapsulated. The encapsulation comprises a first barrier layer 121 and a second barrier layer 122. The barrier layers 121, 122 are connected by adhesive 123 to seal the module. The adhesive 123 can be made by a) hot-melt (thermoplastics) such as ionomers, polyurethanes, polyolefins, polyesters, b) pressure sensitive adhesives c) UV curable adhesives that polymerize by free radical or cationic polymerization such as epoxies or acrylates. It forms a rim of a width r that surrounds the layers 101-105 and fills the volume between the carbon layer 105 and the second barrier layer 122. The rim shall be as small as possible not to affect the geometric fill factor, preferably less than 5mm. UV curable adhesives 123, such as epoxy or acrylates, can be used. Thanks to their properties, narrow rims can be used. At least the first barrier layer 121 that is adjacent to the transparent substrate 101 is also transparent and the adhesive 123 is transparent at least in the volume between the first barrier layer and the transparent substrate 101 so that light can pass to the first electrode 102. The barrier layers 121, 122 can be made of a polymeric substrate (such as polyethyleneterephtalate PET, polyimide (PI), polyamide (PA), polyethylene naphtalate (PEN), PTFE (polytetrafluorethylene), PEEK (Polyether ether ketone), etc..) with at least one metal (such as Al, Ti, Ag, Cr) or metal oxide (such as AlOx, ZrOx, SnOx, ZnOx) for preventing moisture, oxygen, UV permeation. The electric contacts 111, 112 have a form of poles that extend to the external plane of the second barrier layer 122. The adhesive rim 123 presented in this embodiment can be also used to form an adhesive circumferential rim 123 of any other configuration of stack of internal layers.

Fig. 8 shows in a cross-section a sixth embodiment of the single-cell photovoltaic module that corresponds to the fifth embodiment and differs therefrom in that it has a transparent surface layer 101 that functions both as the transparent surface and the first barrier layer, therefore it has an area larger than the area of the first electrode 102 so that a rim is formed around the stack of layers 102-105 by the adhesive 123.

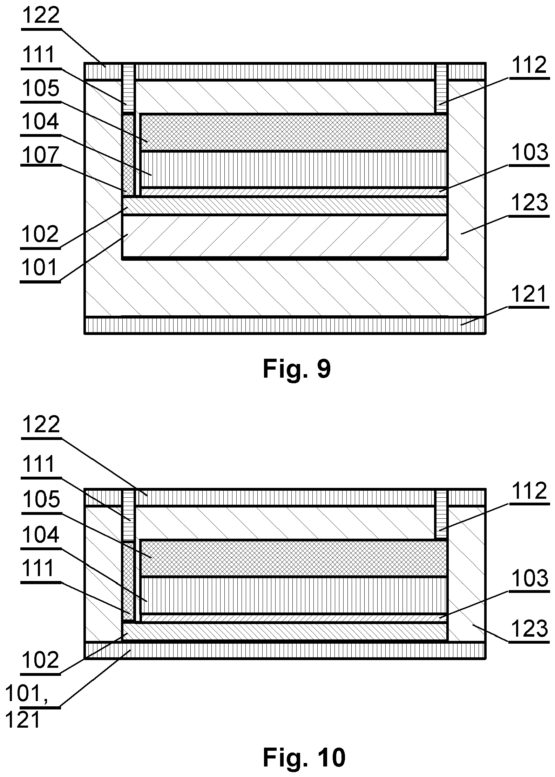

Fig. 9 shows in a cross-section a seventh embodiment of the single-cell photovoltaic module that corresponds to the fifth embodiment and differs therefrom in that it further comprises a carbon post 107 as known from the third embodiment.

Fig. 10 shows in a cross-section an eighth embodiment of the single-cell photovoltaic module that corresponds to the sixth embodiment and differs therefrom in that it further comprises a carbon post 107 as known from the third embodiment.

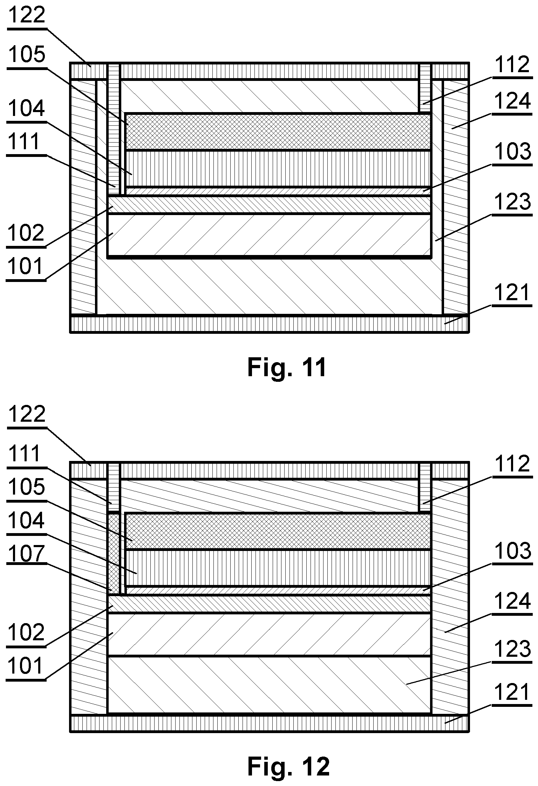

Fig. 11 shows in a cross-section a ninth embodiment of the single-cell photovoltaic module that corresponds to the fifth embodiment and differs therefrom in that it further comprises a rubber circumferential rim 124 at the outer circumference of the module that surrounds the adhesive 123 between the first barrier layer 121 and the second barrier layer 122. The rubber rim 124 can be black, which has the advantage that it provides an optically more uniform appearance in combination with the black color of perovskites and the carbon electrode The rubber rim 124 can be made of synthetic rubbers such as polyisoprene, polyisobutylene, nitrile rubber and silicone rubber. The rubber rim 124 presented in this embodiment can be also used to form a rubber circumferential rim 124 of any other configuration of stack of internal layers.

Fig. 12 shows in a cross-section a tenth embodiment of the single-cell photovoltaic module that corresponds to the seventh embodiment and differs therefrom in that the transparent adhesive is provided only between the first barrier layer 121 and the transparent surface 123 and a rubber rim 124 surrounds the stack of layers 123, 101-105 between the first barrier layer 121 and the second barrier layer 122 and the rubber also fills the volume between the carbon layer 105 and the second barrier layer 122.

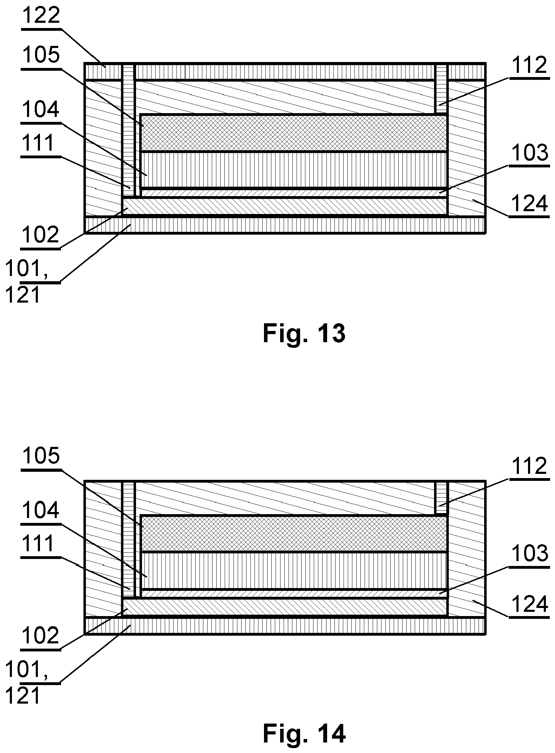

Fig. 13 shows in a cross-section an eleventh embodiment of the single-cell photovoltaic module that corresponds to the sixth embodiment and differs therefrom in that rubber 124 is used instead of adhesive 123. This has the advantage that only a single processing step is required to deposit the complete adhesive layer, and it provides better WVTR values and a homogeneous color over the entire module area. Further embodiments are possible that use rubber 124 instead of adhesive in at least part of volume presented as filled by adhesive.

Fig. 14 shows in a cross-section a twelfth embodiment of the single-cell photovoltaic module that corresponds to the eleventh embodiment and differs therefrom in that it does not have the second barrier layer 122. Such module is useful for applications where the case packaging provides enough protection from the environment, as well as it enables different integration options with IoT hardware due to the direct contact with the adhesive. It also reduces the cost of the device since the barrier substrate is typically quite costy Further embodiments are possible that feature the concept of a first barrier 121 only.

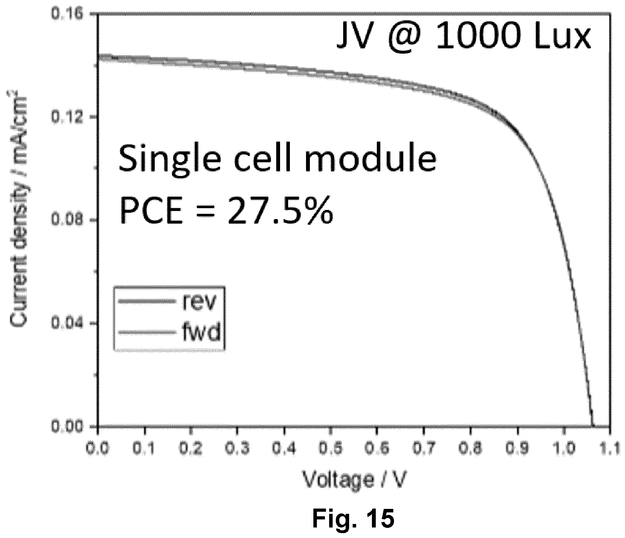

Fig. 15 shows example current-voltage curve for a single-cell photovoltaic module having a structure such as shown in Fig. 1, when illuminated by a 3000K white LED source, having a device area of 2.5 cm², wherein the photoactive layer is made of Cs 0.17 FA 0.83 Pb(I 0.7 Br 0.3) 3, deposited on a SnOx electron transport layer, and a small molecule based interfacial region is present between the photoactive layer and the electrode.

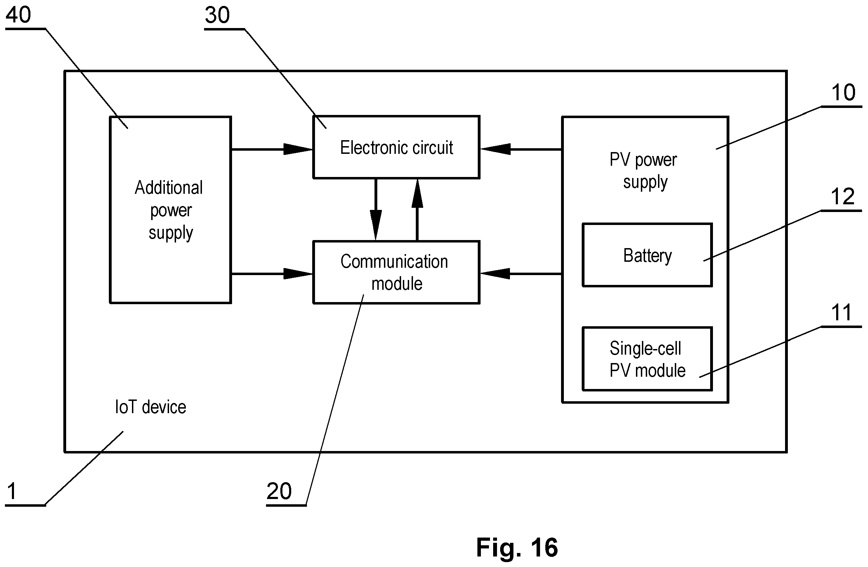

Fig. 16 presents a schematic of the IoT device 1. It comprises an operating electronic circuit 30 that may include a sensor, a processor, a light or sound generator, a display (preferably a low-power display, for example paper display or e-paper) or other similar elements and corresponding electronic components to make the operating electronic circuit 30 operable for example to provide an output signal corresponding to a value of parameter measured by the sensor, a result of operation made by the processor, or to accept an input signal to cause the light or sound generator to emit light or sound or to cause the display to present particular information. The operating electronic circuit is connected to a communication module 20, such as a wireless communication module, configured to receive and/or transmit signals to and/or from the operating electronic circuit 30 from and/or to other devices within the IoT network infrastructure.

For example, in one embodiment, the device may be a home automation temperature sensor configured to measure temperature with a temperature sensor of the operating electronic circuit 30 and send periodically (e.g., every minute) the value of the measured temperature via a ZigBee communication module 20 to a hub configured to collect temperature from a plurality of sensors distributed within the home automation network. In another embodiment, the device may be an electronic shelf label with an LCD or e-paper display of the operating electronic circuit 30 configured to display data according to a message received from a Wi-Fi communication module 20 from a server configured to control the contents of messages (such as price information) on the shelf labels within a department store.

A photovoltaic (PV) power supply 10 comprises the single-cell photovoltaic module 11 and may further comprise a battery 12 to store electric charge generated by the single-cell photovoltaic module 11. The single-cell photovoltaic power supply 10 is connected to supply power to the communication module 20 and optionally to the operating electronic circuit 30, by providing electric power directly from the photovoltaic module 11 or from the battery 12.

Moreover, the IoT device may contain an additional power supply used to power the operating electronic circuit 30 and/or the communication module 20 for example where there is not enough power available from the photovoltaic power supply 10. In such case, for example, when the additional power supply 40 is a replaceable battery, the communication module 20 may be configured to send a message informing that the battery of the additional power supply 40 is running low and shall be replaced.

However, it shall be noted that in a particular embodiment the IoT device may contain the photovoltaic power supply 10 as the sole source of power. In that case, the operation of the device may be dependent on the amount of power available from the photovoltaic power supply 10. For example, the IoT device may be configured to operate in a full functionality mode (such that the photovoltaic power supply 10 provides power both to the operating electronic circuit 30 and to the communication module 20) during periods of high availability of light (i.e. when the amount of electric charge generated by the single-cell photovoltaic module 11 is relatively high (i.e. higher than a threshold value)) such that electric charge is generated by the single-cell photovoltaic module 11 or in a limited functionality mode (such that the photovoltaic power supply 10 provides power solely to the communication module 20 (if the priority is to communicate) or solely to the operating electronic circuit 30 (if the priority is the functionality of the operating electronic circuit 30)) during periods or low availability of light such that little (i.e. less than the threshold value) or no electric charge is provided from the single-cell photovoltaic module 11.

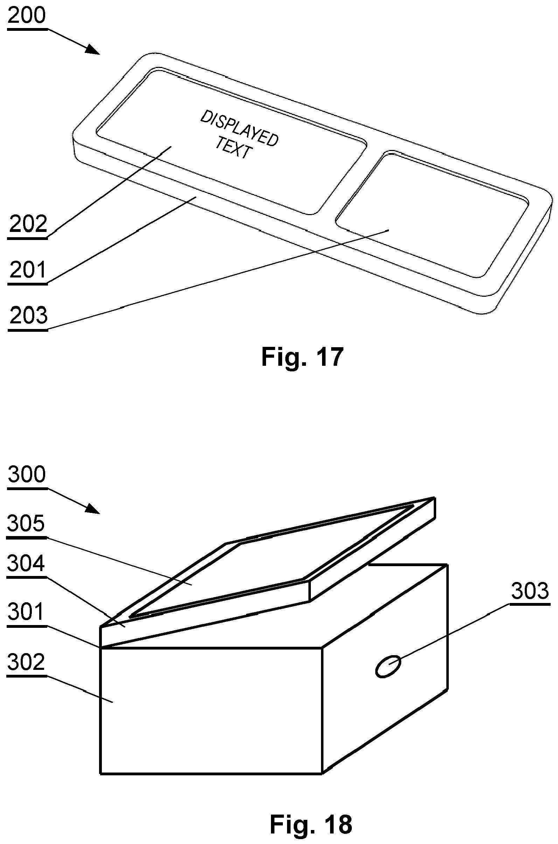

Fig. 17 presents a first example embodiment of the IoT device being an electronic shelf label 200. It contains a single-element casing 201 with embedded paper display 202 and a single-cell photovoltaic module 203, wherein the other elements, such as an operating electronic circuit driving the paper display 202 and a communication module are mounted within the casing 201.

Fig. 18 presents a first example embodiment of the IoT device being a sensing module 300. It has a two-element casing 201 comprising a base 302 with a sensor 303 (e.g., a camera or a motion sensor) and a tiltable frame 304 with a single-cell photovoltaic module 305, wherein the other elements, such as an operating electronic circuit with a processor for collecting and processing signals from the sensor and a communication module are mounted within the base 302.

## Claims

1. A single-cell photovoltaic module (11) comprising:
- a transparent substrate (101) at a first side of the photovoltaic module (11),
- a first electrode (102) deposited on the transparent substrate (101),
- a charge transporting layer (103) deposited on the first electrode (102),
- a photoactive layer (104) comprising perovskite material deposited on the charge transporting layer (103),
- a carbon layer (105) deposited at a second side of the photovoltaic module (11) opposite to the first side,
- at least one first external electric contact (111) connected to the first electrode (102) and at least one second external electric contact (112) connected to the carbon layer (105) so that the at least one second external electric contact (112) is put directly on the carbon layer (105),
wherein the carbon layer (105) is a single uniform layer over the area of the photovoltaic module (11).

2. The photovoltaic module according to claim 1, wherein the carbon layer (305) is designed to extract electron holes.

3. The photovoltaic module according to any of previous claims, wherein the cell photovoltaic module (11) further comprises an electrically conductive interfacial region (106) between the photoactive layer (104) and the carbon layer (105) that is adjacent to the flat photoactive layer (104) and penetrates a porous surface of the carbon layer (106).

4. The photovoltaic module according to any of previous claims, further comprising a carbon pole (107) deposited on the first electrode (102) at a position separated from the edges of a stack formed by the charge transporting layer (103), the photoactive layer (104) and the carbon layer (105), wherein the first external electric contact (111) is connected to the first electrode (102) via the carbon pole (107) and wherein an external planar surface of the carbon pole (107) is coplanar with an external planar surface of the carbon layer (105).

5. The photovoltaic module according to any of previous claims, further comprising a first barrier layer (121) at one of the external planar surfaces of the module.

6. The photovoltaic module according to claim 5, wherein the first barrier layer (121) is transparent and forms the transparent substrate (101).

7. The photovoltaic module according to claim 5 or 6, further comprising a second barrier layer (122) at an external planar surface of the module opposite to the first barrier layer (121).

8. The photovoltaic module according to any of claims 5-7, further comprising an adhesive (123) that forms a rim around a stack of internal layers (101-105) of the photovoltaic module.

9. The photovoltaic module according to any of claims 5-8, further comprising an external circumferential rim (124) made of rubber.

10. An Internet of Things (IoT) device comprising an operating electronic circuit (30), a communication module (20) and a photovoltaic power supply (10) connected to supply power to at least one of the operating electronic circuit (30) or the communication module (20), wherein the photovoltaic power supply (10) comprises the single-cell photovoltaic module (11) according to any of previous claims.

11. The IoT device according to claim 10, wherein the operating electronic circuit comprises at least one of: a sensor, a processor, a light or sound generator or a display.

12. The IoT device according to claim 10 or 11, wherein the photovoltaic power supply (10) is temporarily configurable to supply power to components (30, 20) of the IoT device depending on the temporal amount of electric charge generated by the photovoltaic module (11).

13. The IoT device according to claim 12, configured to operate in a full functionality mode wherein the power from the photovoltaic power supply (10) is supplied to both the operating electronic circuit (20) and to the communication module (30) and in a limited functionality mode wherein the power from the photovoltaic power supply (10) is supplied to solely to either the electronic circuit (20) or to the communication module (30), wherein the limited functionality mode is activated when the amount of charge from the single-cell photovoltaic module (11) is lower than a threshold and the full functionality mode is activated when the amount of charge from the single-cell photovoltaic module (11) is higher than a threshold.

14. The IoT device according to any of claims 10-13, wherein the operating electronic circuit (30), the communication module (20) and the photovoltaic power supply (10) are integrated in a common casing (101, 201).

15. The IoT device according to any of claims 10-14, wherein the photovoltaic power supply (10) further comprises a battery (12) to store electric charge generated by the photovoltaic module (11).
